# EUROPEAN PATENT SPECIFICATION

(11) **EP 4 007 466 B1**
(45) Date of publication and mention of the grant of the patent: **24.01.2024**
(21) Application number: 22164021.2
(22) Date of filing: 24.03.2022
(51) Int. Cl.: H05K 7/14, H05K 7/20

(54) **SERVER CHASSIS DESIGN FOR HIGH POWER DENSITY ELECTRONICS THERMAL MANAGEMENT**
DESIGN VON SERVERGEHÄUSEN FÜR DAS WÄRMEMANAGEMENT VON ELEKTRONIK MIT HOHER LEISTUNGSDICHTE
CONCEPTION DE CHÂSSIS DE SERVEURS POUR LA GESTION THERMIQUE DE L'ÉLECTRONIQUE À HAUTE DENSITÉ DE PUISSANCE

(30) Priority: 25.03.2021 US 202117212130
(43) Date of publication of application: 01.06.2022
(73) Proprietor: Baidu USA LLC, Sunnyvale, California 94089 (US)
(72) Inventor: GAO, Tianyi, Sunnyvale, 94089 (US)
(74) Representative: Maiwald GmbH

(56) References cited:
- CN-A- 112 272 497
- US-A1- 2018 235 102
- US-A1- 2018 310 437
- US-A1- 2019 174 657

## Description

### FIELD

Embodiments of the present invention relate generally to server and data center cooling. More particularly, embodiments of the invention relate to a server chassis design for high power density electronics thermal management.

### BACKGROUND

Generally, computing motherboard includes various interfaces to exchange data with various components. Such interfaces include a peripheral component interconnect (PCI), which accepts a peripheral printed circuit board (PCB). The peripheral PCB (or peripheral device) is generally smaller than the motherboard and may include electronic devices such as, e.g., graphics processing units (GPU), cryptographic accelerators, application specific integrated circuits (ASIC), high computing based IC chips or chiplets, and so forth. Various standards may be used with a peripheral component interconnect, such as, PCI, PCI-X, AGP, PCIe (PCI express), etc. The commonality of these standards is that they all enable intercommunication between components mounted on the motherboard and components mounted on the peripheral PCB, with different speeds.

With the increase in modern computational requirements, more and more tasks are offloaded from the main CPU to other components, including components mounted on the peripheral PCB. Consequently, the processing power of the peripheral PCB increases, which increase the demand for energy, thus increasing heat dissipation.

With the more diverse workload and the computing architecture becoming more heterogenous, a new thermal management solution is needed that is interoperable with different server system design and peripheral PCB configurations.

US2018310437A1 discloses a method and a system for providing cooling to an electronics enclosure that includes redundant cooling in the event of a failure of a cooling fan. The system includes an enclosure configured to support electrical components and a fan chassis. The system also includes a plurality of cooling fans coupled to the fan chassis. Each of the plurality of cooling fans is rotatable relative to the fan chassis between a first orientation in which the fans are operable to direct air into the enclosure and a second orientation. Spacing between adjacent cooling fans is less when the second cooling fan is in the second orientation than when the second cooling fan is in the first orientation. A third one of the plurality of cooling fans automatically rotates from the second orientation to the first orientation upon the second cooling fan moving to the second orientation.

US2019174657A1 provides a system and method for heat dissipation of a storage device. The system includes: a guiding rail mounted in an enclosure of the storage device; a set of fans arranged on the guiding rail and being movable on the guiding rail, the set of fans being configured to dissipate heat of a disk assembly of the storage device; and a controller configured to: obtain a temperature of the disk assembly at a first time point; and in response to the temperature of at least one disk in the disk assembly exceeding a threshold temperature, perform at least one of the following: adjusting a position of at least one of the set of fans; and increasing a rotational speed of at least one of the set of fans.

US2018235102A1 discloses a system which provides redundant cooling of heat generating components within an electronic system with a single row of fans out the use of counter-rotational fans or multiple rows of fan by displacing failed fans in orthogonal directions. The system includes a fan track that has an orthogonal portion and at least one parallel portion. A failed or failing fan is moved from the orthogonal portion of the fan track to the parallel portion of the fan track. A bank of fans are each upon the orthogonal portion of the track. Each fan in the bank of fans acts upon air to produce an airflow. The bank of fans includes a moved fan at least partially filling a void upon the orthogonal portion of the fan track that is created when the failed or failing fan was moved from the orthogonal portion of the fan track to the parallel portion of the fan track.

CN112272497A provides server heat dissipation equipment, a server heat dissipation method and system and a storage medium, belongs to the technical field of heat dissipation and cooling, and solves the problem of resource waste in the heat dissipation process of a server unit in the prior art. The method includes the following steps: acquiring temperature information of a server; wherein the temperature information includes heat distribution information; determining a to-be-cooled area according to the heat distribution information; and controlling the execution device to execute heat dissipation operation on the area to be subjected to heat dissipation. The heat dissipation operation is used for controlling a fan module in the execution device to move to the position corresponding to the area to be subjected to heat dissipation.

### SUMMARY

The invention is set out in the appended set of claims

A server chassis of an electronic rack according to some embodiments of the present disclosure includes a tray to contain one or more information technology (IT) components, wherein the server chassis is stackable in a stack on an electronic rack, wherein each server chassis is divisible into a top section and the bottom section and the bottom section includes the tray, wherein the top section includes: a secured panel, the secured panel being secured to the server chassis; one or more frames adjustably attached to the secured panel; and one or more cooling units attachable to the one or more frames, the one or more cooling units to interface with the one or more IT components to cool the one or more IT components, wherein the one or more frames are relocatable to a different position on the secured panel.

In some embodiments, a frame includes a mountable arm and the one or more cooling units are mountable on the mounting arm.

In some embodiments, the one or more IT components include one or more peripheral component interconnect express (PCIE) devices, and the one or more frames are relocatable to a different position on the secured panel while a server having the one or more IT components is in operation.

In some embodiments, the secured panel includes one or more recessed channels, wherein a first portion of a frame is insertable into a recessed channel of the one or more recessed channels.

In some embodiments, the server chassis further includes a locking kit insertable between a first portion of a frame and the secured panel, the locking kit is turnable to lock the frame to the secured panel.

In some embodiments, a locking kit includes an elliptical-shaped pin and a first end of a frame includes an elliptical-shaped opening, wherein the elliptical-shaped pin is insertable into the elliptical-shaped opening.

In some embodiments, the secured panel includes one or more first cushion layers and one or more second cushion layers facing the one or more first cushion layers, wherein the one or more first cushion layers and the one or more second cushion layers form one or more recessed channels.

In some embodiments, if a locking kit is in a locked position, the locking kit causes a top portion of a frame to press against a second cushion layer, which in turn, causes a PCIE device coupled to the frame to interface with a PCIE slot.

In some embodiments, if a locking kit is in an unlocked position, a PCIE device associated with the locking kit is elevated from a PCIE slot.

In some embodiments, the cooling unit includes a radiator or a cooling fan, wherein the cooling unit can be integrated to the top section, individually, or as a peripheral package, wherein the peripheral package includes the cooling unit and a peripheral device.

An electronic rack of a data center according to some embodiments of the present disclosure includes a plurality of server chassis arranged in a stack, each server chassis is divisible into a top section and a bottom section, wherein the bottom section includes a tray to contain one or more information technology (IT) components, wherein the top section includes: a secured panel, the secured panel being secured to the server chassis; one or more frames adjustably attached to the secured panel; and one or more cooling units attachable to the one or more frames, the one or more cooling units to interface with the one or more IT components to cool the one or more IT components, wherein the one or more frames are relocatable to a different position on the secured panel.

In some embodiments, a frame includes a mountable arm and the one or more cooling units are mountable on the mounting arm.

In some embodiments, the one or more IT components include one or more peripheral component interconnect express (PCIE) devices, and the one or more frames are relocatable to a different position on the secured panel while a server having the one or more IT components is in operation.

In some embodiments, the secured panel includes one or more recessed channels, wherein a first portion of a frame is insertable into a recessed channel of the one or more recessed channels.

In some embodiments, the electronic rack further includes a locking kit insertable between a first portion of a frame and the secured panel, the locking kit is turnable to lock the frame to the secured panel.

An electronic rack of a data center according to some embodiments of the present disclosure includes a secured panel, the secured panel being secured to the electronic rack; one or more frames adjustably attached to the secured panel; and one or more cooling units attachable to the one or more frames, the one or more cooling units to interface with the one or more IT components to cool the one or more IT components, wherein the one or more frames are relocatable to a different position on the secured panel.

In some embodiments, each frame includes a mountable arm and the one or more cooling units are mountable on the mounting arm.

In some embodiments, the one or more IT components include one or more peripheral component interconnect express (PCIE) devices, and the one or more frames are relocatable to a different position on the secured panel while a server having the one or more IT components is in operation.

In some embodiments, the secured panel includes one or more recessed channels, wherein a first portion of a frame is insertable into a recessed channel of the one or more recessed channels.

In some embodiments, the electronic rack further includes a locking kit insertable between a first portion of a frame and the secured panel, the locking kit is turnable to lock the frame to the secured panel.

### BRIEF DESCRIPTION OF THE DRAWINGS

Embodiments of the invention are illustrated by way of example and not limitation in the figures of the accompanying drawings in which like references indicate similar elements.
Figure 1 is a perspective view of a server chassis according to one embodiment.
Figure 2A is a top view of a top cooling section of a server chassis according to one embodiment.
Figure 2B is a front view of a top cooling section illustrating a frame having a single mounting arm according to one embodiment.
Figure 3A is a top view of a top cooling section of a server chassis according to one embodiment.
Figure 3B is a front view of a top cooling section illustrating a frame having double mounting arms according to one embodiment.
Figure 4A is a side view of a top cooling section illustrating a locking kit in an unlocked position according to one embodiment.
Figure 4B is a side view of a top cooling section illustrating a locking kit in a locked position according to one embodiment.
Figure 5 is a front view of a frame illustrating an example locking kit according to one embodiment.
Figure 6 is a front view of a top cooling section illustrating a locked and an unlocked locking kits according to one embodiment.
Figure 7A is a front view of a chassis assembled with one or more cooling units according to one embodiment.
Figure 7B is a side view of a chassis assembled with one or more cooling units according to one embodiment.
Figure 8A is a front view of a chassis assembled with one or more cooling units according to one embodiment.
Figure 8B is a top view of a chassis assembled with one or more cooling units according to one embodiment.
Figure 9A is a front view of a chassis assembled with one or more cooling units support a first peripheral devices arrangement according to one embodiment.
Figure 9B is a front view of a chassis assembled with one or more cooling units support a second peripheral devices arrangement according to one embodiment.
Figure 10 illustrates that a cooling unit is insertable from the top of the chassis according to one embodiment.
Figure 11A is a front view of a chassis illustrating cooling units and peripheral devices are insertable and/or removable from a front/back of a chassis according to one embodiment.
Figure 11B is a side view of a chassis illustrating cooling units and peripheral devices are insertable and/or removable from a front/back of a chassis according to one embodiment.
Figure 12A is a front view of a chassis illustrating spacings when a peripheral PCB is interfaced with a main board according to one embodiment.
Figure 12B is a front view of a chassis illustrating spacings when a peripheral PCB is not interfaced to a main board according to one embodiment.
Figure 13 is a front view of a rack according to one example for better understanding the present invention and being not part of the present invention.
Figure 14 is a perspective view of a server rack with systems of different power densities and peripheral configurations according to one example for better understanding the present invention and being not part of the present invention.
Figure 15 is a block diagram illustrating an example of an electronic rack according to one embodiment.

### DETAILED DESCRIPTION

Various embodiments and aspects of the inventions will be described with reference to details discussed below, and the accompanying drawings will illustrate the various embodiments. The following description and drawings are illustrative of the invention and are not to be construed as limiting the invention. Numerous specific details are described to provide a thorough understanding of various embodiments of the present invention. However, in certain instances, well-known or conventional details are not described in order to provide a concise discussion of embodiments of the present inventions.

Reference in the specification to "one embodiment" or "an embodiment" means that a particular feature, structure, or characteristic described in conjunction with the embodiment can be included in at least one embodiment of the invention. The appearances of the phrase "in one embodiment" in various places in the specification do not necessarily all refer to the same embodiment.

Embodiments of the present disclosure provide a server chassis layout compatible with server systems having different power density and/or peripheral device configurations, in an electronic rack used in a data center. The server chassis is hot-swappable and cooling units used in the server chassis can be serviced and/or replaced without having to remove the server chassis from the electronic rack. The cooling units can support air cooling or liquid/fluid cooling. Note that server systems with different energy density can refer to servers running a different number of peripheral devices. Different peripheral device configurations can refer to peripheral devices with different form factors and/or interfaced at different peripheral expansion locations on a main board.

According to one embodiment, a server chassis of an electronic rack includes: a tray to contain one or more information technology (IT) components. The server chassis is stackable in a stack on an electronic rack, and where each server chassis is divisible into a top section and the bottom section, where the bottom section includes the tray. The top section of the server chassis includes: a secured panel, the secured panel being secured to the server chassis, one or more frames adjustably attached to the secured panel, and one or more cooling units attached to the one or more frames. The one or more cooling units to interface with the one or more IT components to cool the one or more IT components, where the one or more frames are relocatable to a different position on the secured panel.

In one embodiment, a frame includes a mountable arm and the one or more cooling units are mountable on the mounting arm. In one embodiment, the one or more IT components include one or more peripheral component interconnect express (PCIE) devices, and the one or more frames are relocatable to a different position on the secured panel while a server having the one or more IT components is in operation.

In one embodiment, the secured panel includes one or more recessed channels, wherein a first portion of a frame is insertable into a recessed channel of the one or more recessed channels. In one embodiment, the server chassis further includes a locking kit insertable between a first portion of a frame and the secured panel, the locking kit is turnable to lock the frame to the secured panel.

In one embodiment, a locking kit includes an elliptical-shaped pin and a first end of a frame includes an elliptical-shaped opening, wherein the elliptical-shaped pin is insertable into the elliptical-shaped opening. In one embodiment, the secured panel includes one or more first cushion layers and one or more second cushion layers facing the one or more first cushion layers, wherein the one or more first cushion layers and the one or more second cushion layers form one or more recessed channels.

In one embodiment, if a locking kit is in a locked position, the locking kit causes a top portion of a frame to press against a second cushion layer, which in turn, causes a PCIE device coupled to the frame to interface with a PCIE slot. In one embodiment, if a locking kit is in an unlocked position, a PCIE device associated with the locking kit is elevated from a PCIE slot. In one embodiment, the cooling unit includes a radiator and a cooling fan.

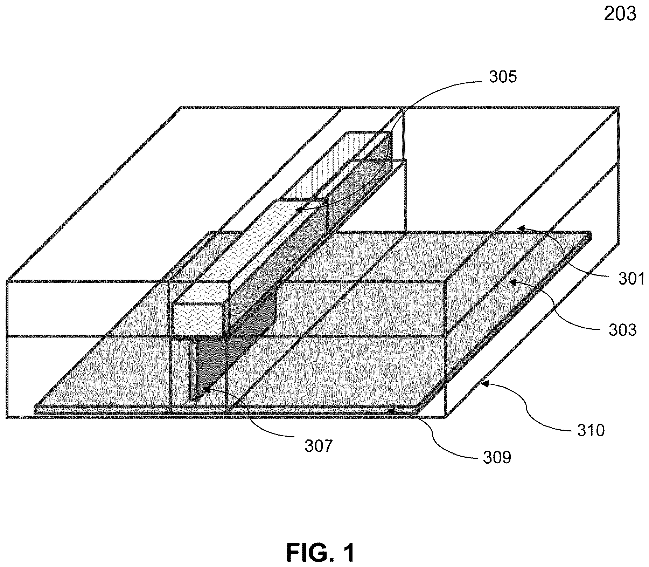

Figure 1 is a perspective view of a server chassis 203 according to one embodiment. In one embodiment, server chassis 203 includes cooling unit 305 and a peripheral device 307 to be cooled by cooling unit 305. Server chassis 203 may include one or more IT components and/or a tray to contain one or more IT components (e.g., central processing units or CPUs, and/or peripheral devices). IT components may perform data processing tasks, where the IT components may include software installed in a storage device, loaded into the memory, and executed by one or more processors to perform the data processing tasks. Server chassis 203 may include a host server or a compute server (such as CPU server or GPU server). The host server (having one or more CPUs) typically interfaces with clients over a network (e.g., Internet) to receive a request for a particular service such as storage services (e.g., cloud-based storage services such as backup and/or restoration), executing an application to perform certain operations (e.g., image processing, deep data learning algorithms or modeling, etc., as a part of a software-as-a-service or SaaS platform). In response to the request, the host server distributes the tasks to a compute server (having one or more GPUs) managed by the host server. The compute servers perform the actual tasks, which may generate heat during the operations.

In one embodiment server chassis 203 can be divisible into a top cooling section 301 and a bottom IT component section 303. The top section includes various cooling components to cool a server in the server chassis, such as cooling units 305. Bottom IT component section 303 can include, a tray 310, main electronic board 309 placed on tray 310, and one or more peripheral devices 307 connected to main electronic board 309. Peripheral device 307 can be a GPU, application specific integrated circuits (ASIC), computing accelerators, high computing based IC chips or chiplets, and so forth. The peripheral devices can interface with main electronic board 309 through a peripheral expansion bus, such as PCIe.

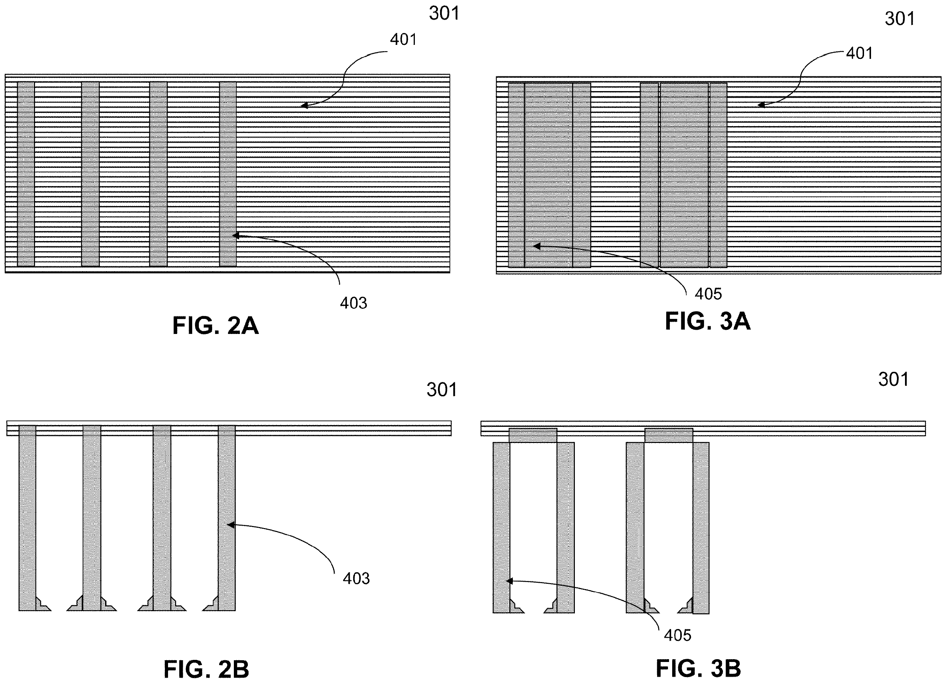

Figures 2A and 3A are top views of a top cooling section 301 of a server chassis 203 according to some embodiments. Figures 2B and 3B are front views of a top cooling section 301 illustrating a frame 403 having a single mounting arm and a frame 405 having double mounting arms according to some embodiments.

Referring to Figures 2-3, top cooling section 301 can include a secured panel 401. The secured panel 401 can be either integrated as one piece with server chassis 203 or can be a separate panel which can be flexibly assembled to server chassis 203. In one embodiment, secured panel 401 can be secured to a side panel of server chassis.

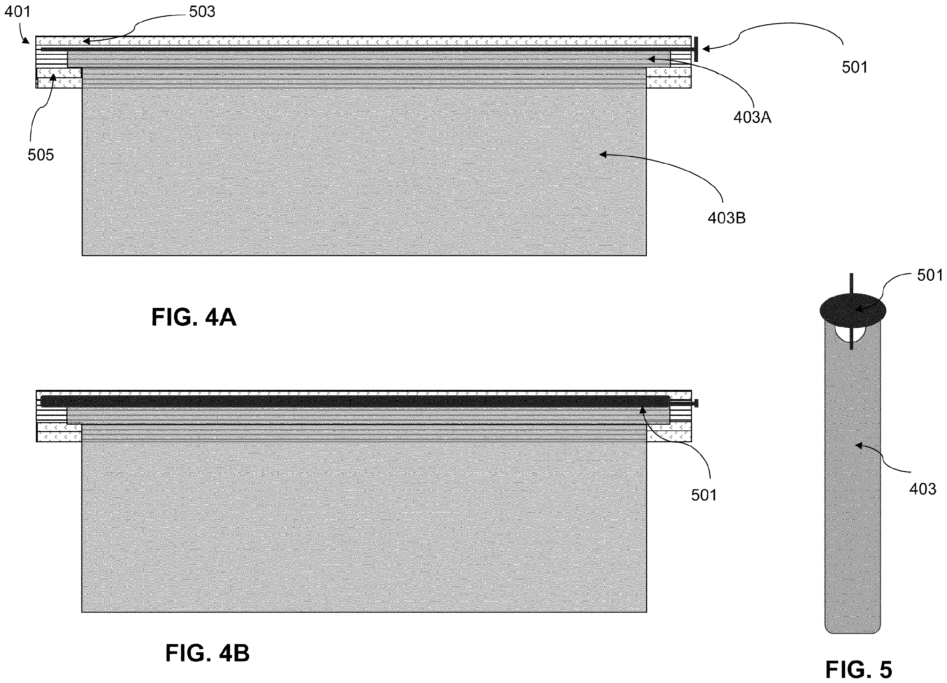

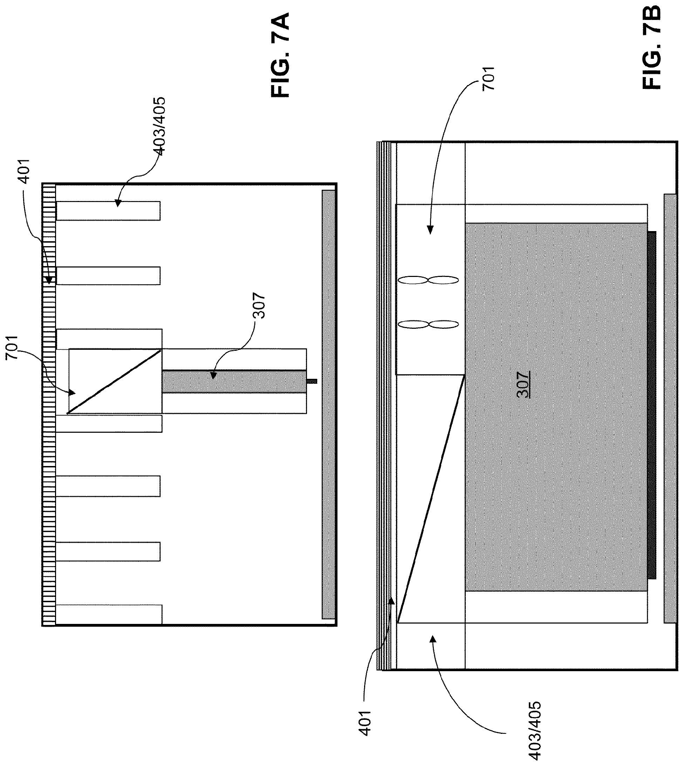

In one embodiment, secured panel 401 can be used to secure one or more frames 403-405 to server chassis 203. For example, secure panel 401 can include one or more recessed channels. Frames 403-405 can slide into a recessed channel and frames 403-405 are lockable to the recessed channel via a locking kit (as further shown in Figures 5A-5C). In one embodiment, frames 403-405 is either a single frame 403 or a double frame 405. Single frame 403 can include a single fixed mounting arm, and double frame 405 can include two fixed mounting arms. Frames 403-405, in turn, are used to attach to a cooling unit, as further shown in Figures 7-9. Note that the length of the arms of frames 403-405 can vary to support cooling units of different form factors.

As shown in Figures 2-3, the number of frames 403-405, as well as the locations of frames 403-405 can vary. The varying frame counts and/or locations enable the secured panel 401 to support server systems with different power densities and peripheral devices of different configurations.

In one embodiment, double frame 405 can be used to attach to a cooling unit having standard form factor cooling devices, since a spacing between the two arms of a double frame is fixed and cannot be changed. In one embodiment, single frame 403 can be used to attach a cooling unit with cooling devices of a non-standard form factor. In one embodiment, an arm of a single frame or a double frame can be used to secure cooling devices on one side of the arm or both sides of the arm. In some embodiments, the dimensions of the frame can vary.

Figure 4A is a side view of a top cooling section illustrating a locking kit in an unlocked position according to one embodiment. Figure 4B is a side view of a top cooling section illustrating a locking kit in a locked position according to one embodiment.

As shown in Figure 4A, secured panel 401 includes one or more top cushion layers 503 and one or more bottom cushion layers 505. In one embodiment, top and bottom cushion layers 503-505 include layers of flexible materials and/or mechanical cushions. In one embodiment, a flexible material/mechanical cushion of a top cushion layer 503 faces a flexible material/mechanical cushion of a bottom cushion layer 505. In one embodiment, secured panel 401 includes a structural beam that extends from a top cushion layer 503 to a bottom cushion layer 505 to provide structural support between top and bottom cushion layers 503-505.

In one embodiment, two cushion layers 503-505 form a recessed channel for a frame to be assembled to secured panel 401. A frame 403 can include two portions: a top portion 403A and a bottom portion 403B. Top portion 403A can be shaped to mechanically fit in the recessed channel formed by cushion layers 503-505 within secured panel 401. Bottom portion 403B can be used to integrate with one or more cooling units.

In one embodiment, a locking kit 501 is provided to structurally lock a frame 403 to a secure panel 401. When locking kit 501 is in an unlocked position, as shown in figure 4A, a position of a frame can be slidably adjusted along a recessed channel. In one embodiment, locking kit 501 can be turned to place locking kit 501 in a locked position. As shown in figure 4B, locking kit 501 in a locked position secures frame 403 against a top cushion layer 503 or a bottom cushion layer 505 of secured panel 401.

Figure 5 is a front view of a frame illustrating an example locking kit according to one embodiment. As shown in Figure 5, locking kit 501 can include a tube or plate with an elliptical-shaped body, where one end of frame 403-405 can include an elliptical opening for locking kit 501 to be inserted in between frame 403-405 and a top cushion layer. In one embodiment, locking kit 501 can resemble a rod with a flat plate body having an elliptical-shaped head. In one embodiment, when locking kit is inserted into frame 403, in between frame 403 and a top cushion layer of secured panel 401, locking kit 501 can be turned approximately 90 degrees to lock frame 403 onto secured panel 401. In one embodiment, when locking kit 501 is in a locked position, rod body of locking kit 501 is pressed against a top cushion layer 503 and frame 403. In one embodiment, when locking kit 501 is in a locked position, top portion 403A of frame is pressed against a bottom cushion layer 505 of secured panel 401.

In one embodiment, secure panel 401 and frames 403-405 are used as structural support for both cooling units and peripheral devices coupled to frames 403-405.

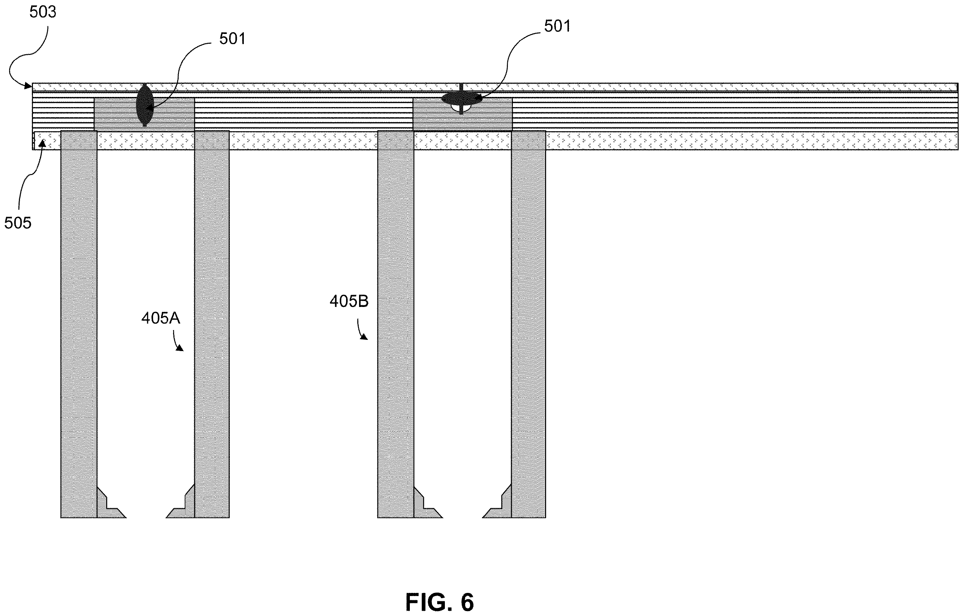

Figure 6 is a front view of a top cooling section illustrating a locked and an unlocked locking kits according to one embodiment. Figure 6 shows that a double frame 405 includes a top portion and two mounting arms. The top portion of frame 405 is assembled in a recessed channel, in between a top cushion layer 503 and a bottom cushion layer 505, which together supports the top portion of double frame 405. Frame 405A on the left shows locking kit 501 in a locked position and frame 405B on the right shows locking kit 501 in an unlocked position.

Figure 7A is a front view of a chassis 203 assembled with one or more cooling units according to one embodiment. Figure 7B is a side view of a chassis 203 assembled with one or more cooling units according to one embodiment.

As shown in Figures 7A-7B, a cooling unit 701 together with an electronic package 307 are assembled to chassis 203 using secured panel 401 and frames 403/405. It can be seen that frames 403/405 are used for securing a cooling unit 701. In one embodiment, cooling unit 701 can include a heat exchanger, a radiator and/or a fan, where cooling unit 701 is situated between any two arms of frames 403/405.

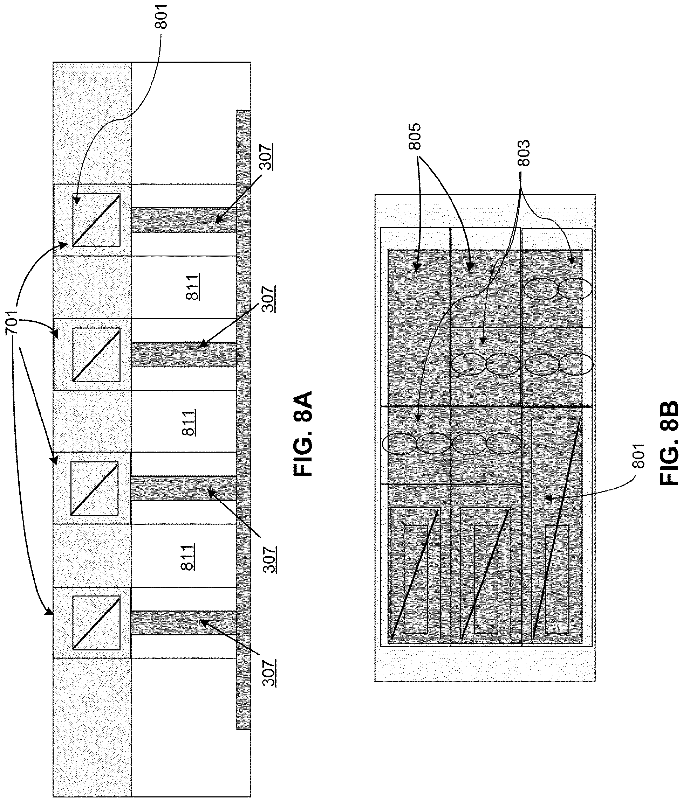

Figure 8A is a front view of a chassis assembled with one or more cooling units according to one embodiment. Figure 8B is a top view of the chassis of Figure 8A.

Figures 8A-8B show four cooling units 701 are assembled in chassis 203. Figure 8B shows secured panel 401 is covered by cooling units 701, where cooling units 701 are secured by one or more frames 403-405 (not shown). In one embodiment, cooling units 701 can include one or more cooling devices. The cooling device can be a fan, radiator, heat exchanger, a liquid cooled cold plate, etc.

In one embodiment, referring to Figure 8B, spacings not covered by cooling components 801-803 can be covered by blank panels 805. The blank panels 805 together with cooling units 701 can form air channels 811 between peripheral devices to channel an airflow from a frontend to a backend of server chassis.

Figure 8B shows channels that are formed between frames 403-405 can be equipped with different cooling components, such as fans 803, and heat exchangers 801. In one embodiment, length of arms of frames 403-405 (not shown) can be different, e.g., full length or half-length frames. For example, large cooling fans 803 can be assembled among one or more full length frames and then inserted into server chassis. Then, cooling heat exchangers 801 can be assembled between a full length frame and a half-length frame and inserted into server chassis. In one embodiment, a cooling fan 803 can be used as a shared fan for one or more heat exchangers 801.

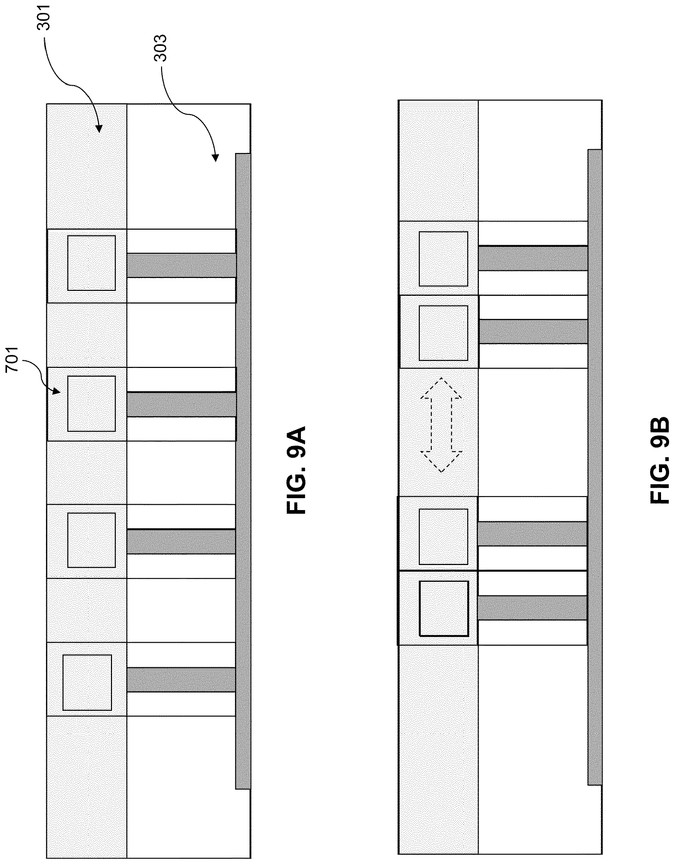

Figure 9A is a front view of a chassis assembled with one or more cooling units support a first peripheral devices arrangement according to one embodiment. Figure 9B is a front view of a chassis assembled with one or more cooling units support a second peripheral devices arrangement according to one embodiment.

As shown in Figures 9A-9B, because main server boards can vary in the number of peripheral expansions and their locations, thus, server IT component section 303 may be configured with a different number of peripheral devices at different locations. For example, IT components in section 303 can have various number of PCIe expansion slots and the PCIe expansion slots locations may vary. Here, top section 301 allows a different number of cooling units 701 to be installed and at various locations, thus, this flexibility of top section 301 improves interoperability among different server board designs.

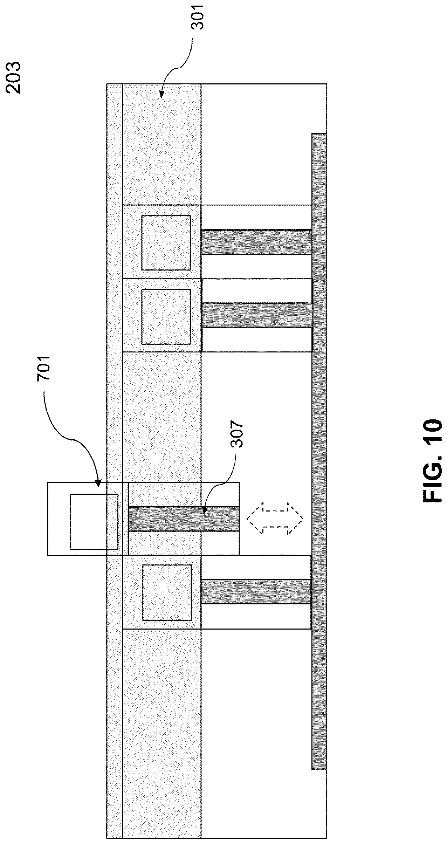

Figure 10 illustrates that a cooling unit is insertable from the top of chassis 203 according to one embodiment. As shown, in one embodiment, the design of secured panel should allow a cooling unit to be installed to a server before installing the server to a rack. In one embodiment, part of top section 301 is not fully covered by secured panel 401 (not shown). For example, recessed channels formed by secured panel 401 (not shown) may not span a full length of chassis 203. In one embodiment, recessed channels can be formed at opposing sides of a secured panel while a midportion of secured panel has an opening for a cooling unit to be inserted into. In this case, when server chassis 203 is detached from an electronic rack, frame 403-405 and cooling unit 701, together with peripheral device 307 can be inserted into server 203 from the opening. A locking kit then secures frame 403-405 to secured panel 401.

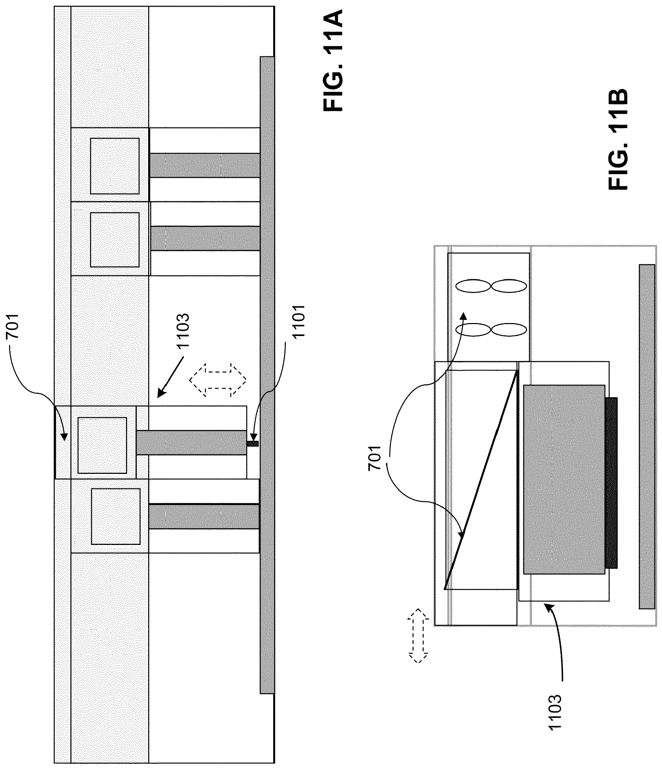

Figure 11A is a front view, and Figure 11B is a side view, of a chassis illustrating cooling units and peripheral devices are insertable and/or removable from a front/back of a chassis according to one embodiment. Figures 11A-11B show that server chassis 203 allows the addition and/or removal of cooling units and/or electronics packages even while the server chassis is populated in an electronic rack. In one embodiment, frames, when unlocked, can be moved along a recessed channel formed by two cushion layers. In one embodiment, an entire peripheral package 1103 (e.g., electronics package and cooling unit), when unlocked, can be lifted as shown in figure 11B. For example, when a cooling unit 701 is required to be serviced or removed from chassis 203, one or more locking kits (not shown) of frames can be turned and then the frames can be lifted to remove a peripheral package 1103 from a peripheral connector 1101. Peripheral package 1103 can then be moved along a recessed channel and removed horizontally, from either the front side or rear side of chassis 203.

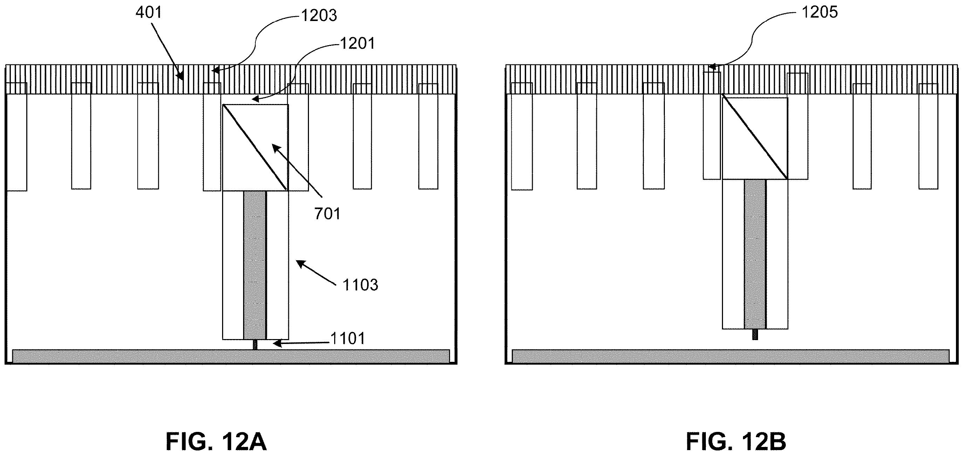

Figure 12A is a front view of a chassis illustrating one or more spacings when a peripheral PCB is interfaced with a main board according to one embodiment. Figure 12B is a front view of Figure 12A. Figures 12A-12B show that chassis 204 with spacings 1201-1205 can be used for the addition and/or removal of a peripheral device 1103 from chassis 203 while chassis 203 remains in an electronic rack. For example, spacing 1201 ensures an adequate clearance between cooling unit 701 and secured panel 401 when peripheral device 1103 is unlocked and removed through a front or rear side of chassis. Spacings 1203 and 1205 can be a distance from a frame to a top cushion layer of secured panel 401 when frame is locked and when frame is unlocked, respectively. For example, as shown in Figure 12A, when a frame is locked, there exists spacing 1203 between a frame and a top cushion layer of secured panel 401. As shown in Figure 12B, when a frame is locked, there exists spacing 1205 between a frame and a top cushion layer of secured panel 401. In one embodiment, when a frame is locked, peripheral device is interfaced with a peripheral slot 1101. Spacings 1203-1205 can provide adequate clearance so peripheral package 1103 can interface to and/or de-interfaced from peripheral slot 1101 with a turn of a locking kit.

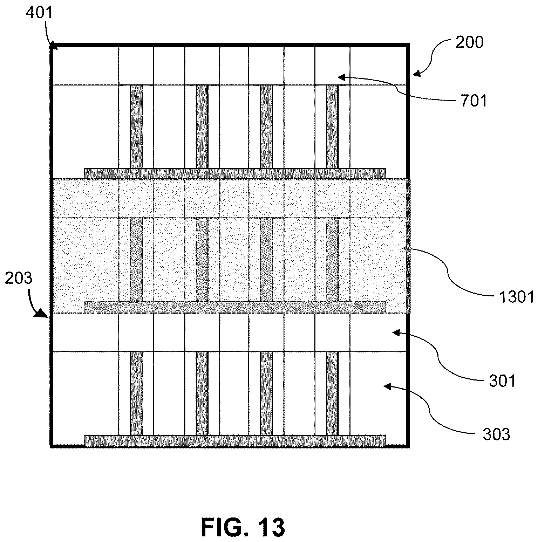

Figure 13 is a front view of a rack according to one example for better understanding the present invention and being not part of the present invention. Figure 13 illustrates a rack with different server system implementations. For example, in one embodiment, a server system can include a chassis 203 having top and bottoms sections 301-302. In one embodiment, a cooling section, such as cooling section 301 of Figure 1, can be implemented as part of a server system, as illustrated by server 1301. In this case, a secured panel (including a locking kit) of a cooling section can be structurally secured to a main board of server 1301 instead of a server chassis. In some embodiments, secured panel 401, which supports a same locking mechanism that is described in Figure 5, can be implemented directly on rack 200, instead of being implemented as part of a server chassis. In this case, rack 200 can include one or more secured panels 401, where a cooling unit 701 can be directly attached to the one or more secured panels of rack 200.

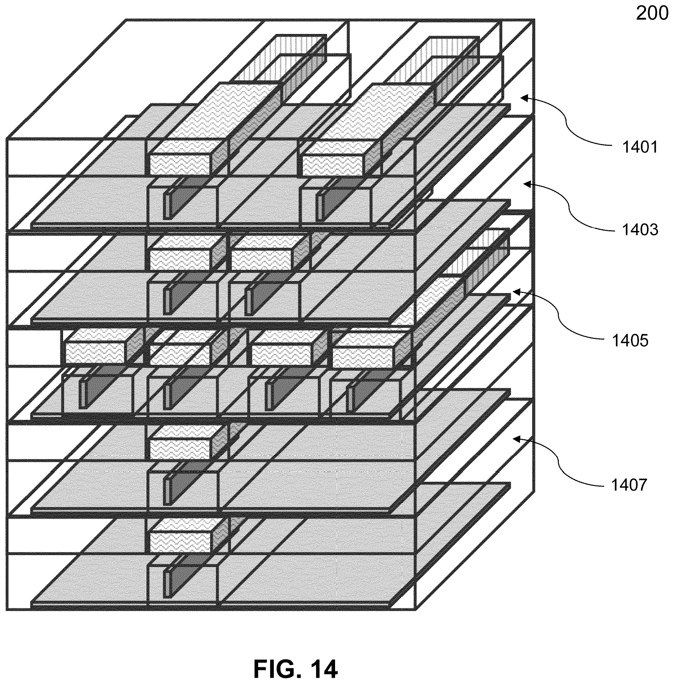

Figure 14 is a perspective view of a server rack 200 with server systems of different power densities and peripheral configurations according to one example for better understanding the present invention and being not part of the present invention. Electronic rack 200 can include a number of server slots (e.g., standard shelves or chassis configured with an identical or similar form factor), and a number of server chassis capable of being inserted into and removed from the server slots. Each server chassis can be associated with a host server or a compute server. Moreover, one or more cooling fans can be associated with the server chassis to provide air cooling to the host/compute servers contained therein. Cool airflows can enter electronic rack 200 through their frontend and warm/hot airflows can exit the electronic rack 200 from their backend.

As shown in Figure 14, server systems 1401-1407 can be configured with different power densities and/or different peripheral device arrangements within a single rack, using server chassis 203. For example, server systems 1401-1407 can be server setups with different numbers of peripheral devices and/or peripheral configurations. System 1405 can be a high power density and high performance system with four peripheral devices. Server systems 1401-1403 can have a same power density but with different server board layouts. Thus, rack 200 can include server systems 1401-1407 configured differently using server chassis 203 to satisfy different computing requirements. Moreover, an airflow management and cooling system configuration can be individualized within each server system 1401-1407, independent of one another.

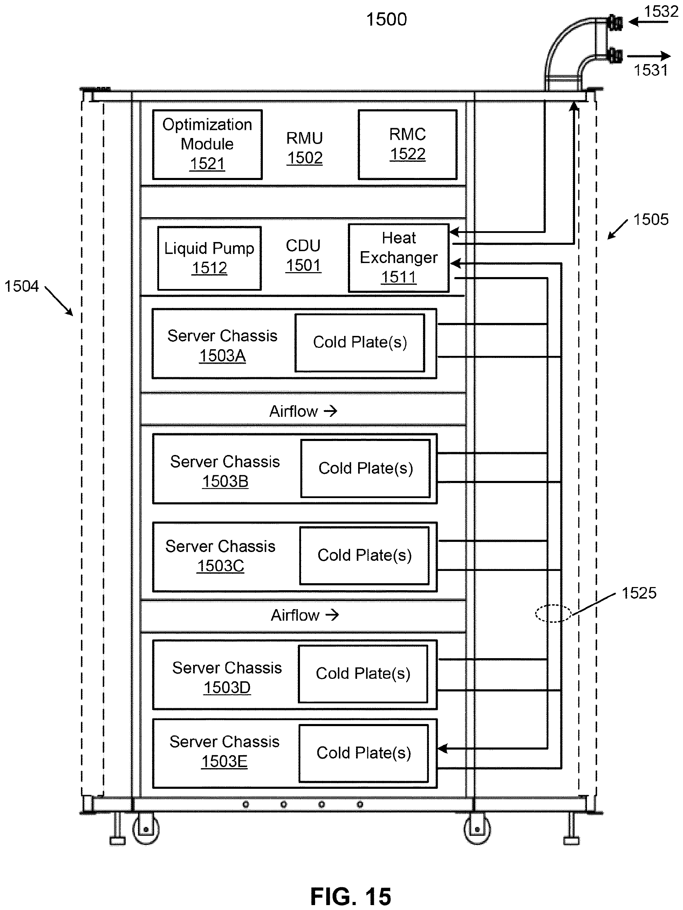

Figure 15 is block diagram illustrating an electronic rack according to one embodiment. Electronic rack 1500 may represent any of the electronic racks as described throughout this application. According to one embodiment, electronic rack 1500 includes, but is not limited to, coolant distribution unit (CDU) 1501, rack management unit (RMU) 1502, and one or more server chassis 1503A-1503E (collectively referred to as server chassis 1503). Server chassis 1503 can be inserted into an array of server slots (e.g., standard shelves) respectively from frontend 1504 or backend 1505 of electronic rack 1500. Note that although there are five server chassis 1503A-1503E shown here, more or fewer server chassis may be maintained within electronic rack 1500. Also note that the particular positions of CDU 1501, RMU 1502, and/or server chassis 1503 are shown for the purpose of illustration only; other arrangements or configurations of CDU 1501, RMU 1502, and/or server chassis 1503 may also be implemented. In one embodiment, electronic rack 1500 can be either open to the environment or partially contained by a rack container, as long as the cooling fans can generate airflows from the frontend to the backend.

In addition, for at least some of the server chassis 1503, an optional fan module (not shown) is associated with the server chassis. Each of the fan modules includes one or more cooling fans. The fan modules may be mounted on the backends of server chassis 1503 or on the electronic rack to generate airflows flowing from frontend 1504, traveling through the air space of the sever chassis 1503, and existing at backend 1505 of electronic rack 1500.

In one embodiment, CDU 1501 mainly includes heat exchanger 1511, liquid pump 1512, and a pump controller (not shown), and some other components such as a liquid reservoir, a power supply, monitoring sensors and so on. Heat exchanger 1511 may be a liquid-to-liquid heat exchanger. Heat exchanger 1511 includes a first loop with inlet and outlet ports having a first pair of liquid connectors coupled to external liquid supply/return lines 1531-1532 to form a primary loop. The connectors coupled to the external liquid supply/return lines 1531-1532 may be disposed or mounted on backend 1505 of electronic rack 1500. The liquid supply/return lines 1531-1532, also referred to as room liquid supply/return lines, may be coupled to an external cooling system.

In addition, heat exchanger 1511 further includes a second loop with two ports having a second pair of liquid connectors coupled to liquid manifold 1525 (also referred to as a rack manifold) to form a secondary loop, which may include a supply manifold (also referred to as a rack liquid supply line or rack supply manifold) to supply cooling liquid to server chassis 1503 and a return manifold (also referred to as a rack liquid return line or rack return manifold) to return warmer liquid back to CDU 1501. Note that CDUs 1501 can be any kind of CDUs commercially available or customized ones. Thus, the details of CDUs 1501 will not be described herein.

Each of server chassis 1503 may include one or more IT components (e.g., central processing units or CPUs, general/graphic processing units (GPUs), memory, and/or storage devices). Each IT component may perform data processing tasks, where the IT component may include software installed in a storage device, loaded into the memory, and executed by one or more processors to perform the data processing tasks. Server chassis 1503 may include a host server (referred to as a host node) coupled to one or more compute servers (also referred to as computing nodes, such as CPU server and GPU server). The host server (having one or more CPUs) typically interfaces with clients over a network (e.g., Internet) to receive a request for a particular service such as storage services (e.g., cloud-based storage services such as backup and/or restoration), executing an application to perform certain operations (e.g., image processing, deep data learning algorithms or modeling, etc., as a part of a software-as-a-service or SaaS platform). In response to the request, the host server distributes the tasks to one or more of the computing nodes or compute servers (having one or more GPUs) managed by the host server. The compute servers perform the actual tasks, which may generate heat during the operations.

Electronic rack 1500 further includes optional RMU 1502 configured to provide and manage power supplied to servers 1503, and CDU 1501. RMU 1502 may be coupled to a power supply unit (not shown) to manage the power consumption of the power supply unit. The power supply unit may include the necessary circuitry (e.g., an alternating current (AC) to direct current (DC) or DC to DC power converter, battery, transformer, or regulator, etc.,) to provide power to the rest of the components of electronic rack 1500.

In one embodiment, RMU 1502 includes optimization module 1521 and rack management controller (RMC) 1522. RMC 1522 may include a monitor to monitor operating status of various components within electronic rack 1500, such as, for example, computing nodes 1503, CDU 1501, and the fan modules. Specifically, the monitor receives operating data from various sensors representing the operating environments of electronic rack 1500. For example, the monitor may receive operating data representing temperatures of the processors, cooling liquid, and airflows, which may be captured and collected via various temperature sensors. The monitor may also receive data representing the fan power and pump power generated by the fan modules and liquid pump 1512, which may be proportional to their respective speeds. These operating data are referred to as real-time operating data. Note that the monitor may be implemented as a separate module within RMU 1502.

Based on the operating data, optimization module 1521 performs an optimization using a predetermined optimization function or optimization model to derive a set of optimal fan speeds for the fan modules and an optimal pump speed for liquid pump 1512, such that the total power consumption of liquid pump 1512 and the fan modules reaches minimum, while the operating data associated with liquid pump 1512 and cooling fans of the fan modules are within their respective designed specifications. Once the optimal pump speed and optimal fan speeds have been determined, RMC 1522 configures liquid pump 1512 and cooling fans of the fan modules based on the optimal pump speeds and fan speeds.

As an example, based on the optimal pump speed, RMC 1522 communicates with a pump controller of CDU 1501 to control the speed of liquid pump 1512, which in turn controls a liquid flow rate of cooling liquid supplied to the liquid manifold 1525 to be distributed to at least some of server chassis 1503. Similarly, based on the optimal fan speeds, RMC 1522 communicates with each of the fan modules to control the speed of each cooling fan of the fan modules, which in turn control the airflow rates of the fan modules. Note that each of fan modules may be individually controlled with its specific optimal fan speed, and different fan modules and/or different cooling fans within the same fan module may have different optimal fan speeds.

Note that the rack configuration as shown is described for the purpose of illustration only; other configurations or arrangements may also be applicable. For example, CDU 1501 may be an optional unit. The cold plates of server chassis 1503 may be coupled to a rack manifold, which may be directly coupled to room manifolds 1531-1532 without using a CDU. Although not shown, a power supply unit may be disposed within electronic rack 1500. The power supply unit may be implemented as a standard chassis identical or similar to a sever chassis, where the power supply chassis can be inserted into any of the standard shelves, replacing any of server chassis 1503. In addition, the power supply chassis may further include a battery backup unit (BBU) to provide battery power to server chassis 1503 when the main power is unavailable. The BBU may include one or more battery packages and each battery package include one or more battery cells, as well as the necessary charging and discharging circuits for charging and discharging the battery cells.

## Claims

1. A server chassis (203, 204, 1503) of an electronic rack (200, 1500), comprising:
a tray (310) to contain one or more IT components (309), wherein the server chassis (203, 204, 1503) is stackable in a stack on an electronic rack (200, 1500), wherein each server chassis (203, 204, 1503) is divisible into a top section (301) and a bottom section (303) and the bottom section (303) includes the tray (310), wherein the top section (301) comprises:
a secured panel (401), the secured panel (401) being secured to the server chassis (203, 204, 1503);
one or more frames (403-405) adjustably attached to the secured panel (401); and
one or more cooling units (701) attached to the one or more frames (403-405), the one or more cooling units (701) to interface with the one or more IT components (309) to cool the one or more IT components (309), wherein the one or more frames (403-405) are relocatable to a different position on the secured panel (401).

2. The server chassis (203, 204, 1503) of claim 1, wherein a frame (403-405) includes a mountable arm and the one or more cooling units (701) are mountable on the mounting arm.

3. The server chassis (203, 204, 1503) of claim 1, wherein the one or more IT components (309) include one or more PCIE devices, and the one or more frames (403-405) are relocatable to a different position on the secured panel (401) while a server having the one or more IT components (309) is in operation.

4. The server chassis (203, 204, 1503) of claim 1, wherein the secured panel (401) includes one or more recessed channels, wherein a first portion of a frame (403) is insertable into a recessed channel of the one or more recessed channels.

5. The server chassis (203, 204, 1503) of claim 1, further comprising a locking kit (501) insertable between a first portion of a frame (403) and the secured panel (401), the locking kit (501) is turnable to lock the frame to the secured panel (401).

6. The server chassis (203, 204, 1503) of claim 1, wherein a locking kit (501) includes an elliptical-shaped pin and a first end of a frame includes an elliptical-shaped opening, wherein the elliptical-shaped pin is insertable into the elliptical-shaped opening.

7. The server chassis (203, 204, 1503) of claim 1, wherein the secured panel (401) includes one or more first cushion layers (503) and one or more second cushion layers (505) facing the one or more first cushion layers, wherein the one or more first cushion layers (503) and the one or more second cushion layers (505) form one or more recessed channels.

8. The server chassis (203, 204, 1503) of claim 1, wherein if a locking kit (501) is in a locked position, the locking kit (501) causes a top portion (403A) of a frame (403) to press against a second cushion layer (505), which in turn, causes a PCIE device coupled to the frame (403) to interface with a PCIE slot.

9. The server chassis (203, 204, 1503) of claim 1, wherein if a locking kit (501) is in an unlocked position, a PCIE device associated with the locking kit (501) is elevated from a PCIE slot.

10. The server chassis (203, 204, 1503) of claim 1, wherein the cooling unit (701) includes a radiator or a cooling fan, wherein the cooling unit (701) can be integrated to the top section (301), individually, or as a peripheral package, wherein the peripheral package (1103) includes the cooling unit (701) and a peripheral device (307).

11. An electronic rack (200, 1500) of a data center, comprising:
a plurality of server chassis (203, 204, 1503) according to any one of claims 1 to 10, the plurality of server chassis (203, 204, 1503) being arranged in a stack.

## Patentansprüche

1. Servergehäuse (203, 204, 1503) eines Schaltschrankes (200, 1500), umfassend:
eine Ablage (310) zur Aufnahme einer oder mehrerer IT-Komponenten (309), wobei das Servergehäuse (203, 204, 1503) in einem Stapel in einem Schaltschrank (200, 1500) stapelbar ist, wobei jedes Servergehäuse (203, 204, 1503) in eine obere Sektion (301) und eine untere Sektion (303) teilbar ist und die untere Sektion (303) die Ablage (310) aufweist, wobei die obere Sektion (301) umfasst:
eine gesicherte Platte (401), wobei die gesicherte Platte (401) an dem Servergehäuse (203, 204, 1503) gesichert ist;
einen oder mehrere Rahmen (403-405), die verstellbar an der gesicherten Platte (401) befestigt sind; und
eine oder mehrere Kühleinheiten (701), die an dem einen oder den mehreren Rahmen (403-405) befestigt sind, wobei die eine oder die mehreren Kühleinheiten (701) mit der einen oder den mehreren IT-Komponenten (309) verbunden sind, um die eine oder die mehreren IT-Komponenten zu kühlen (309), wobei der eine oder die mehreren Rahmen (403-405) auf der gesicherten Platte (401) an eine andere Position verschoben werden können.

2. Servergehäuse (203, 204, 1503) nach Anspruch 1, wobei ein Rahmen (403-405) einen montierbaren Arm aufweist und die eine oder die mehreren Kühleinheiten (701) an den Montagearm montierbar sind.

3. Servergehäuse (203, 204, 1503) nach Anspruch 1, wobei die eine oder die mehreren IT-Komponenten (309) eines oder mehrere PCIE-Geräte aufweisen und der eine oder die mehreren Rahmen (403-405) auf der gesicherten Platte (401) an eine andere Position verschoben werden können, während ein Server, die die eine oder die mehreren IT-Komponenten (309) hat, in Betrieb ist.

4. Servergehäuse (203, 204, 1503) nach Anspruch 1, wobei die gesicherte Platte (401) einen oder mehrere ausgesparte Kanäle aufweist, wobei ein erster Abschnitt eines Rahmens (403) in einen ausgesparten Kanal des einen oder der mehreren ausgesparten Kanäle einsetzbar ist.

5. Servergehäuse (203, 204, 1503) nach Anspruch 1, ferner umfassend einen Verriegelungssatz (501), der zwischen einem ersten Abschnitt eines Rahmens (403) und der gesicherten Platte (401) einsetzbar ist, wobei der Verriegelungssatz (501) drehbar ist, um den Rahmen an der gesicherten Platte (401) zu verriegeln.

6. Servergehäuse (203, 204, 1503) nach Anspruch 1, wobei ein Verriegelungssatz (501) einen elliptisch geformten Stift aufweist und ein erstes Ende eines Rahmens eine elliptisch geformte Öffnung aufweist, wobei der elliptisch geformte Stift in die ellipsenförmige Öffnung einsetzbar ist.

7. Servergehäuse (203, 204, 1503) nach Anspruch 1, wobei die gesicherte Platte (401) eine oder mehrere erste Polsterschichten (503) und eine oder mehrere zweite Polsterschichten (505), die der einen oder mehreren ersten Polsterschichten zugewandt sind, aufweist, wobei die eine oder die mehreren ersten Polsterschichten (503) und die eine oder die mehreren zweiten Polsterschichten (505) einen oder mehrere ausgesparte Kanäle bilden.

8. Servergehäuse (203, 204, 1503) nach Anspruch 1, wobei, wenn sich ein Verriegelungssatz (501) in einer verriegelten Position befindet, der Verriegelungssatz (501) bewirkt, dass ein oberer Abschnitt (403A) eines Rahmens (403) gegen eine zweite Polsterschicht (505) gedrückt wird, was wiederum dazu führt, dass ein an den Rahmen (403) gekoppeltes PCIE-Gerät mit einem PCIE-Steckplatz verbunden wird.

9. Servergehäuse (203, 204, 1503) nach Anspruch 1, wobei, wenn sich ein Verriegelungssatz (501) in einer entriegelten Position befindet, ein mit dem Verriegelungssatz (501) verbundenes PCIE-Gerät aus einem PCIE-Steckplatz angehoben wird.

10. Servergehäuse (203, 204, 1503) nach Anspruch 1, wobei die Kühleinheit (701) einen Kühler oder einen Kühlventilator aufweist, wobei die Kühleinheit (701) einzeln oder als Peripheriepaket in die obere Sektion (301) integriert werden kann, wobei das Peripheriepaket (1103) die Kühleinheit (701) und ein Peripheriegerät (307) aufweist.

11. Schaltschrank (200, 1500) eines Rechenzentrums, umfassend:
eine Vielzahl von Servergehäusen (203, 204, 1503) nach einem der Ansprüche 1 bis 10, wobei die Vielzahl von Servergehäuse (203, 204, 1503) in einem Stapel angeordnet sind.

## Revendications

1. Châssis de serveur (203, 204, 1503) d'une baie électronique (200, 1500), comprenant :
un plateau (310) pour contenir un ou plusieurs composants IT (309), dans lequel le châssis de serveur (203, 204, 1503) est empilable en un empilement sur une baie électronique (200, 1500), dans lequel chaque châssis de serveur (203, 204, 1503) est divisible en une section supérieure (301) et une section inférieure (303) et la section inférieure (303) inclut le plateau (310), dans lequel la section supérieure (301) comprend :
un panneau sécurisé (401), le panneau sécurisé (401) étant fixé au châssis de serveur (203, 204, 1503) ;
un ou plusieurs cadres (403-405) attachés de manière ajustable au panneau sécurisé (401) ; et
une ou plusieurs unités de refroidissement (701) attachées à l'un ou plusieurs cadres (403-405), l'une ou plusieurs unités de refroidissement (701) pour réaliser l'interface avec l'un ou plusieurs composants IT (309) pour refroidir l'un ou plusieurs composants IT (309), dans lequel l'un ou plusieurs cadres (403-405) sont repositionnables à une position différente sur le panneau sécurisé (401).

2. Châssis de serveur (203, 204, 1503) de la revendication 1, dans lequel un cadre (403-405) inclut un bras montable et l'une ou plusieurs unités de refroidissement (701) sont montables sur le bras de montage.

3. Châssis de serveur (203, 204, 1503) de la revendication 1, dans lequel l'un ou plusieurs composants IT (309) incluent un ou plusieurs dispositifs PCIE, et l'un ou plusieurs cadres (403-405) sont repositionnables à une position différente sur le panneau sécurisé (401) alors qu'un serveur ayant l'un ou plusieurs composants IT (309) est en fonctionnement.

4. Châssis de serveur (203, 204, 1503) de la revendication 1, dans lequel le panneau sécurisé (401) inclut une ou plusieurs rainures en creux, dans lequel une première partie d'un cadre (403) est insérable dans une rainure en creux de l'une ou plusieurs rainures en creux.

5. Châssis de serveur (203, 204, 1503) de la revendication 1, comprenant en outre un kit de verrouillage (501) insérable entre une première partie d'un cadre (403) et le panneau sécurisé (401), le kit de verrouillage (501) est apte à tourner pour verrouiller le cadre au panneau sécurisé (401).

6. Châssis de serveur (203, 204, 1503) de la revendication 1, dans lequel un kit de verrouillage (501) inclut une cheville de forme elliptique et une première extrémité d'un cadre inclut une ouverture de forme elliptique, dans lequel la cheville de forme elliptique est insérable dans l'ouverture de forme elliptique.

7. Châssis de serveur (203, 204, 1503) de la revendication 1, dans lequel le panneau sécurisé (401) inclut une ou plusieurs premières couches de coussin (503) et une ou plusieurs deuxièmes couches de coussin (505) faisant face à la une ou plusieurs premières couches de coussin, dans lequel l'une ou plusieurs premières couches de coussin (503) et l'une ou plusieurs deuxièmes couches de coussin (505) forment une ou plusieurs rainures en creux.

8. Châssis de serveur (203, 204, 1503) de la revendication 1, dans lequel si un kit de verrouillage (501) est dans une position verrouillée, le kit de verrouillage (501) amène une partie supérieure (403A) d'un cadre (403) à appuyer contre une deuxième couche de coussin (505), qui amène à son tour un dispositif PCIE couplé au cadre (403) à réaliser l'interface avec une fente PCIE.

9. Châssis de serveur (203, 204, 1503) de la revendication 1, dans lequel si un kit de verrouillage (501) est dans une position déverrouillée, un dispositif PCIE associé au kit de verrouillage (501) est surélevé d'une fente PCIE.

10. Châssis de serveur (203, 204, 1503) de la revendication 1, dans lequel l'unité de refroidissement (701) inclut un radiateur ou un ventilateur de refroidissement, dans lequel l'unité de refroidissement (701) peut être intégrée à la section supérieure (301), individuellement, ou comme ensemble périphérique, dans lequel l'ensemble périphérique (1103) inclut l'unité de refroidissement (701) et un dispositif périphérique (307).

11. Baie électronique (200, 1500) d'un centre de données, comprenant :
une pluralité de châssis de serveur (203, 204, 1503) selon l'une quelconque des revendications 1 à 10, la pluralité de châssis de serveur (203, 204, 1503) étant arrangée en un empilement.
